# EUROPEAN PATENT APPLICATION

(11) **EP 1 944 815 A1**
(43) Date of publication of application: **16.07.2008**
(21) Application number: 08250010.9
(22) Date of filing: 02.01.2008
(51) Int. Cl.: H01L 41/193, H01L 41/26, B06B 1/06, G01N 29/24

(54) **Piezoelectric element, manufacture and ultrasonic probe**

(30) Priority: 09.01.2007 JP 2007001159
(71) Applicant: Konica Minolta Medical & Graphic, Inc., Hino-shi, Tokyo 191-8511 (JP)
(72) Inventor: Habu, Takeshi, c/o Konica Minolta Med. & Graphic Inc., Hino-shi, Tokyo, 191-8511 (JP); Hosoi, Yuji, c/o Konica Minolta Med. & Graphic Inc., Hino-shi, Tokyo, 191-8511 (JP); Sasaki, Takayuki, c/o Konica Minolta Med. & Graphic Inc., Hino-shi, Tokyo, 191-8511 (JP); Takeyama, Toshihisa, c/o Konica Minolta Med. & Graphic Inc., Hino-shi, Tokyo, 191-8511 (JP)
(74) Representative: Alton, Andrew

(57) **Abstract**

A piezoelectric element is disclosed, comprising at least two electrodes having therebetween a high-dielectric layer and a low-dielectric layer, wherein the high-dielectric layer is comprised of an organic material. An ultrasonic probe for transmitting and receiving ultrasonic waves is also disclosed, comprising the piezoelectric element.

## Description

This application claims priority from Japanese Patent Application No. JP2007-001159 filed on January 9, 2007, which is incorporated hereinto by reference.

### FIELD OF THE INVENTION

The present invention relates to a piezoelectric element and a preparation method thereof, and an array type ultrasonic probe provided with the piezoelectric element and used for medical diagnosis.

### BACKGROUND OF THE INVENTION

An ultrasonograph is a medical imaging technique which obtains cross-sectional images of soft tissue in vivo low-invasively from the body surface via an ultrasonic pulse reflection technique. This ultrasonograph, which has advantages of being compact, low-priced, highly safe without being exposed to X-rays and enables bloodstream imaging by employing a Doppler effect, is broadly employed in imaging the cardiovascular system (coronary artery of heart), the digestive system (stomach and intestines), the internal medicine system (liver, pancreas, spleen), the urology system (kidney, bladder) and the gynecology system. An ultrasonic probe used in such medical ultrasonograph, which performs transmitting and receiving at high-sensitivity and high-resolution, generally uses an inorganic piezoelectric element, a so-called PZT. For such ultrasonograph, a single-type probe or an array-type probe having disposed plural probes is often used as a transceiving piezoelectric probe. Such an array-type probe can provide precise images, which has become widespread as medical images for examination and diagnosis.

Harmonic imaging diagnosis using harmonic signals can provide clear diagnostic images which cannot be obtained in conventional B-mode diagnosis has become the standard diagnostic modality.

Harmonic imaging has many advantages such that a low side-probe level relative to the basic wave results in an enhanced S/N ratio and superior contrast resolution, a high frequency reduces the beam width, leading to enhanced lateral resolving power, a low sound pressure and reduced variation of sound pressure at a short distance causes no multiple reflection (i.e., artifact rarely occurs and speckle noises are reduced), and attenuation beyond a focal point which is similar to the basic wave can obtain a greater staging, as compared to ultrasonic waves basically having a frequency of a harmonic wave.

A specific structure of an array type ultrasonic probe used for harmonic imaging uses a piezoelectric oscillator in which the respective oscillator elements constituting the array are a broad-band integral type. There is generally employed a method in which transmittal of the basic wave is conducted in the frequency region of the low-frequency side of broad-band characteristics and reception of the harmonic wave is conducted in the frequency region of the highfrequency side. In conventional ultrasonic probes is known a technique to achieve enhancement of sensitivity, as described in, for example, JP-A 63-252140 (hereinafter, the term JP-A refers to Japanese Patent Application Publication), in which an oscillator having a minute columnar piezoelectric element fixed in an organic compound such as epoxy resin is used as a transceiving element and the columnar element is allowed to oscillate to enable enhanced sensitivity.

Narrow-band ultrasonic waves ar used so that the spectrum of a basic wave transmitting ultrasonic waves does not overlap with a harmonic wave receiving ultrasonic. Such narrow-band ultrasonic waves generally are a long-tailing ultrasonic pulse signal, which adversely affects depth resolution.

As a specific structure of an array type ultrasonic probe used for harmonic imaging was also proposed a separated transceiving type probe in which a transmitting piezoelectric oscillator and a receiving piezoelectric oscillator was separately disposed, as described in JP-A Nos. 8-187245 and 11-276478. For instance, JP-A No. 11-276478 proposed that a first piezoelectric layer was provided, comprising arrayed plural piezoelectric elements with a first acoustic impedance and playing a role of transceiving ultrasonic waves of a central frequency f₁; and a second piezoelectric layer was further provided on the first layer, comprised of an array of plural piezoelectric elements with a second acoustic impedance and playing a role of receiving ultrasonic of central frequency f₂=2f₁, which however were not able to realize sufficient sensitivity.

Further, as an ultrasonic receiving element of enhanced sensitivity was attempted layering of inorganic piezoelectric elements, whereby apparent impedance was lowered, electric compatibility with driving circuitry was enhanced and the electric field strength applied to the elements was increased, causing a large strain and resulting in enhanced receiving sensitivity. However, in the layered structure, transmitting sensitivity increases proportionally to the number of layers but receiving sensitivity is reversely proportional thereto, leading to disadvantages for harmonic imaging.

A composite oscillator described in JP-A No. 63-252140 is manufactured by forming a columnar structure by cutting an inorganic piezoelectric element with a cutting machine such as a dicer, followed by the cut groove being filled with organic material. In an array type probe, dividing into the individual channels is also similarly conducted by a cutter such as a dicer.

However, the transceiving frequency of an ultrasonic probe, which depends on the thickness of an inorganic piezoelectric element is increased, the size of the columnar structure or channel pitch decreases. Accordingly, a machining process using a cutting machine such as dicer increased and mechanical strength of the inorganic probe was lowered, producing problems of breakage or deteriorated characteristics due to heat or strain during machining, which could not be ignored, while lowered production yield or deteriorated performance tended to be induced. Further, grinding or polishing of both end surfaces is essential for production of a transmitting piezoelectric probe corresponding to a desired frequency, causing an increase of manufacturing cost. Thus, as compared with organic material, inorganic material used for manufacturing a probe produced problems in manufacturing probes.

However, the use of an organic material required an effective polarization treatment to provide piezoelectricity to the organic material, such as high-voltage application or a corona discharge treatment. However, such a treatment resulted in a disadvantage such as damaging or breaking the organic membrane, rendering it difficult to apply high-voltage.

To solve the foregoing problems, JP-A No. 6-342947 described a technique of interleaving a dielectric. This technique proposed sandwiching a porous membrane with a dielectric material or injecting a dielectric oil into pores in the polarization treatment of a porous membrane. However, in cases where an organic piezoelectric layer is coated on an inorganic piezoelectric layer which has been subjected to a polarization treatment, interleaving a dielectric material can certainly avoid dielectric breakdown but results in lowered efficiency of the polarization treatment. Further, the use of a dielectric oil produces problems with surface electrode baking, due to insufficient wiping or providing an electrode, resulting in increased cleaning cost.

### SUMMARY OF THE INVENTION

In view of the foregoing problems in the prior art, the present invention has come into being to solve those problems relating to an ultrasonic probe. It is an object of the invention to obtain an ultrasonic probe employing an array type ultrasonic probe in which the operation of transmitting ultrasonic waves and that of receiving ultrasonic waves are separated and which uses an inorganic piezoelectric element material for transmission and a high-sensitive inorganic piezoelectric element material for reception. Specifically, it is an object of the invention to provide a piezoelectric element therefor, a manufacturing method of the same and an array type ultrasonic probe provided with the piezoelectric element.

One aspect of the invention is directed to a piezoelectric element comprising a piezoelectric layer comprising a high-dielectric layer exhibiting a high dielectric constant and a low-dielectric layer exhibiting a low dielectric constant, wherein the high-dielectric layer is comprised of an organic material and electrodes are disposed on both sides of the piezoelectric layer.

Another aspect of the invention is directed to a method of manufacturing a piezoelectric element as described above, wherein at least one the high-dielectric layer and the low-dielectric layer is subjected to a polarization treatment.

Further, another aspect of the invention is directed to an ultrasonic probe provided with a piezoelectric element, wherein the probe comprises a transceiving piezoelectric element that is the piezoelectric element described above.

### DETAILED DESCRIPTION OF THE INVENTION

The piezoelectric element of the invention comprises a composite dielectric layer comprising a high-dielectric layer exhibiting a high relative dielectric constant and a low-dielectric layer exhibiting a low relative dielectric constant, in which the high-dielectric layer comprises an organic material, and electrodes are disposed at least on both sides of the composite dielectric layer.

In one preferred embodiment of the invention, the low-dielectric layer comprises an organic material. The low dielectric layer preferably exhibits a dielectric constant of 1 to 10.

The manufacturing method of the piezoelectric element of the invention comprises the steps of (i) forming a high-dielectric layer and forming the low-dielectric on the high-dielectric layer to form a composite dielectric layer, and (ii) disposing a first electrode on one side of the composite dielectric layer and disposing a second electrode on the other side of the composite dielectric layer, wherein at least one the high-dielectric layer and the low-dielectric layer is subjected to a polarization treatment.

In one preferred embodiment of the manufacturing method of the piezoelectric element, the high-dielectric layer and the low-dielectric layer are simultaneously subjected to a polarization treatment before disposing the electrodes or after disposing one of the electrodes or both of the electrodes. In another preferred embodiment of the manufacturing method of the invention, only the high-dielectric layer is subjected to a polarization treatment. In the manufacturing method, the polarization treatment is performed preferably with applying a voltage of 1 MV/m to 1 GV/m. The polarization treatment preferably employs a direct current (dc) application, an alternating current (ac) application or a corona discharge application.

An ultrasonic probe of the invention has a basic structure in which at least one side of a high-dielectric layer (also denoted as a ferroelectric layer) and a low-dielectric layer coalesce each other and electrodes are disposed on both external sides of the coalesced material. This probe may be as a transmitting and receiving (or transceiving) type which enables transmitting and receiving ultrasonic waves. Alternatively, commonly known inorganic piezoelectric elements having a relatively high-receiving sensitivity such as quartz or PZT are employed as a transmitting element and further thereon is superimposed an organic thin-layer comprised of a high-dielectric layer (a ferroelectric thin-layer) and a low-dielectric layer (low-dielectric thin-layer), which can be used as a transmission reception separation type of piezoelectric element. The transmission reception separation type piezoelectric element may have a layered structure of a transmitting piezoelectric element and a receiving piezoelectric element sandwiching an electrode.

The high-dielectric layer (in this case, typically a ferroelectric substance layer) relating to the invention preferably is a material exhibiting a dielectric constant of more than 10 and is also a material which has a broad band gap and which also behaves as an insulator to direct current voltage. Such material is divided into organic substances and inorganic substances, but in the invention, an organic substance is preferred and a polymer compound is more preferred. In the interior of a dielectric substance, electrons cannot freely move but when an electric field is externally applied to the dielectric substance, atoms or molecules constituting the dielectric substance are separated to the positively polarized portion and to the negatively polarized portion. Orientation polarization occurs when molecules constituting a dielectric substance have polarity. When no electric field is applied, molecules are randomly oriented and exhibit no electric dipole as a whole but when applying an electric field, molecules are oriented to form dipoles. When applying an electric field over a sufficiently long period of time, charge carriers move in the interior of a dielectric substance, forming dipoles. A piezoelectric element of a ferroelectric substance coalesced with a low-dielectric substance exhibits piezoelectricity as a whole. In the invention, an organic piezoelectric layer is disposed on a conventional inorganic piezoelectric layer subjected to a polarization treatment, forming a piezoelectric element which exhibits a high sensitivity and rarely results in dielectric breakdown.

A vinylidene fluoride-trifluoroethylene copolymer [hereinafter, also denoted as P(VDF-TrFE)] or a vinylidene fluoride-tetrafluoroethylene copolymer [also denoted as P(VDF-TeFE)] is preferably used for the high-dielectric layer (ferroelectric substance layer) of the invention. The ferroelectric substance is defined as a substance in which spontaneous polarization occurs, its polarizing direction can be artificially varied by an electric field and artificially varying polarization (residual polarization) remains when the electric field becomes zero.

With respect to molecular weight of a raw material polymer of the high-dielectric layer (ferroelectric substance layer), in general, polymers form a dielectric layer having a flexibility and softness characteristic to polymers. In P(VDF-TrFE) and/or P(VDF-TeFE), the use of a polymeric piezoelectric material exhibiting a melt flow rate of not more than 0.3 g/min at 230 °C (preferably not more than 0.02 g/min and more preferably not more than 0.01 g/min) can provide a thin-layer for a high-sensitive piezoelectric layer.

In the foregoing, VDF, TrFE and TeFE refer to vinylidene fluoride, trifluoroethylene and tetrafluoroethylene, respectively; and P(VDF-TrFE) and P(VDF-TeFE) refer to VDF-TrFE copolymer and VDF-TeFE copolymer, respectively. In the case of vinylidene fluoride/trifluoroethylene copolymer or P(VDF-TrFE), for example, its electromechanical bond constant (piezoelectric effect) in the thickness direction is variable based on the copolymerization ratio and the copolymerization ratio of the former (or vinylidene fluoride) is preferably from 60 to 99 mol%. However, superimposing an inorganic piezoelectric element and an organic piezoelectric element depends on a method using an organic binding agent and its optimum value is variable. The copolymerization ratio of the former (or vinylidene fluoride) is more preferably from 85 to 99 mol%. A copolymer of 85-99 mol% vinylidene fluoride and 1-15 mol% perfluoroalkyl vinyl ether (PAF), perfluoroalkoxyethylene (PAE) or perfluorohexaethylene inhibits a transmitting basic wave and results in enhanced sensitivity for receiving a harmonic component in the combinationg a transmitting inorganic piezoelectric element with a receiving organic piezoelectric. In addition to tetrafluoroethylene or trifluoroethylene, a perfluoroalkyl vinyl ether (PFA) a perfluoroalkoxyethylene (PAF), and perfluorohexaethylene are also preferred as a component copolymerizing with vinylidene fluoride. In the foregoing perfluoroalkyl vinyl ether (PFA) perfluoroalkoxyethylene (PAF), a perfluoroalkyl group or a perfluoroalkoxy group preferably has 1 to 4 carbon atoms.

Polyurea is also preferably used as a ferroelectric substance for the high-dielectric layer. A polyurea is obtained by polymerization of a diamine monomer compound with a diisocyanate monomer compound.

Examples of diamine compounds usable as a diamine monomer include 4,4'-diaminodiphenylmethane (also denoted as MDA), 4,4'-diaminodiphenyl ether, 4,4'-diamino-3,3'-dimethylphenylmethane, 3,3'-dimethoxy-4,4'-diaminobiphenyl, 3,3'-dimethyl-4,4'-diaminobiphenyl, 2,2'-dichloro-4,4'-diamino-5,5'-dimethoxybiphenyl, 2,2'5,5'-tetrachloro-4,4'-diaminobiphenyl, 4,4'-methylene-bis(2-chloroaniline), 4,4'-diaminodiphenylsulfone, 2,7-diaminofluorene, 4,4'-diamino-p-terphenyl, and 1,3-diamino-5-cyanobenzene.

Examples of diisocyanate compounds usable as a diisocyanate monomer include 3,3'-dimethyldiphenyl-4,4'-diisocyanate, o-dianisidine diisocyanate, methylenebis(4-isocyanate-3-methylbenzene), methylenebis(4-isocyanate-2-methylbenzene), methylenebis(o-chlorophenyldiisocyanate), 5-chloro-2,4-toluenediisocyanate, 4,4'-diphenylmethane diisocyanate, 2,4-toluene diisocyanate (2,4-TDI), 2,6-toluene diisocyanate (2,6-TDI), bis(4-isocyanatophenyl)ether, dicyclohexylmethane-4,4'-diisocyanatep-phenylenediisocyanate, p-xylene diisocyanate, tetramethylxylene diisocyanate, 1,5-naphthalene diisocyanate, 2,6-naphthalene diisocyanate, trans-1,4-cyclohexyldiisocyanate, trans-1,4-cyclohexyldiisocyanate, isophorone diisocyanate, and 1,3-bis(isocyanatomethyl)benzene.

Preferred examples of a polyurea a combination of diamine/diisocyanate include 4,4'-diaminodiphenylmethane/4,4'-dipheneylmethane diisocyanate, 4,4'-diaminodipheneylmethane/2,4-toluene diisocyanate, 4,4'-diaminodipheneylmethane/2,6-toluene diisocyanate, 4,4'-diaminodipheneylmethane/4,4'dipheneylmethane diisocyanate, 4,4'-diaminodipheneylmethane/2,4-toluene diisocyanate, 4,4'-diaminodiphenyl ether/2,6-toluene diisocyanate, 4,4'-diamino-3,3'-dimethyldiphenylmethane/4,4'dipheneylmethane diisocyanate, 4,4'-diamino-3,3'-dimethyldiphenylmethane/2,4-toluene diisocyanate, 4,4'-diamino-3,3'-dimethyldiphenylmethane/2,6-toluene diisocyanate, 3,3'-dimethoxy-4,4'-diaminobiphenyl/4,4'-diphenylmethane diisocyanate, 3,3'-dimethoxy-4,4'-diaminobiphenyl/2,4-toluenediisocyanate, 3,3-dimethoxy-4,4'-diaminobiphenyl/2,6-toluene diisocyanate, 3,3'-dimethyl-4,4'-diaminobiphenyl/4,4'-diphenylmethane diisocyanate, 3,3-dimethyl-4,4'-diaminobiphenyl/2,4-toluene diisocyanate, 3,3'-dimethyl-4,4'-diaminobiphenyl/2,6-toluene diisocyanate, 4,4'-methylene-bis(2-chloroaniline)/4,4'-diphenylmethane diisocyanate, 4,4'-methylene-bis(2-chloroaniline)/2,4-toluene diisocyanate, 4,4'-methylene-bis(2-chloroaniline)/2,6-toluene diisocyanate.

The preferred low-dielectric layer relating to the invention is a thin layer exhibiting superior heat resistance and voltage resistance and examples thereof include two or more copolymers and a blend-molded material.

There may be contained microparticles of an inorganic dielectric material to control the dielectric constant of the high-dielectric layer (ferroelectric thin-layer). As such microparticles are cited materials used for an inorganic piezoelectric element, as described later.

The thickness of a dielectric resin layer, depending on sensitivity and frequency characteristics, is preferably from 10 to 1000 µm, and more preferably from 20 to 500 µm. In the invention, the dielectric constant is represented by a relative dielectric constant. The relative dielectric constant is a physical constant representing a feature of a dielectric substance and refers to the ratio of the dielectric constant of a dielectric substance to the dielectric constant of vacuum. The low-dielectric layer of the invention preferably exhibits a relative dielectric constant of 1.0 to 10.0, more preferably 1.5 to 10 and still more preferably 2.0 to 9.0. A relative dielectric constant of more than 10 renders it complicated to control the piezoelectric frequency. The use of a dielectric resin layer exhibiting a relative dielectric constant of more than 10 can be achieved by the combined use with a dielectric resin layer exhibiting a relative dielectric constant of not more than 10. Alternatively, formation of a large number of pores can reduce the dielectric constant of the whole layer. In that case, there is also produced a problem in that mechanical strength is lowered but it can be adapted by taking into account the mechanical strength. Specific examples of a resin exhibiting a low relative dielectric constant are shown below, in which the value enclosed within the parenthesis represents a dielectric constant that is a relative dielectric constant.
P1: poly(methyl methacrylate) (3.0)
P2: polyacrylonitrile (4.0)
P3: acetylcellulose (3.0)
P4: acetate resin (3.4)
P5: aniline resin (3.5)
P6: aniline formaldehyde resin (4.0)
P7: aminoalkyl resin (4.0)
P8: alkyd resin (5.0)
P9: Teflon (trade name) 4F (2.0)
P10: natural rubber (3.0)
P11: acrylonitrile-styrene copolymer (or AS resin) (3.0)
P12: acrylonitrile-butylene-styrene copolymer (or ABS resin) (3.1)
P13: ethyl cellulose (3.1)
P14: nylon (4.0)
P15: nylon 6 (3.7)
P16: ethylene resin (2.2)
P17: nylon 66 (3.4)
P18: epoxy resin (2.5)
P19: ebonite (2.6)
P20: soft vinyl chloride resin (3.3)
P21: soft vinyl butyral resin (3.9)
P22: vinyl chloride resin (3.3)
P23: vinylidene chloride resin (3.0)
P24: chlorinated polyether resin (2.9)
P25: urea formaldehyde resin (7.0)
P26: neoprene (7.0)
P27: polyvinyl alcohol (1.8)
P28: fluororesin (5.0)
P29: hard vinyl chloride resin (2.9)
P30: hard vinyl butyral resin (3.33)
P31: furan resin (5.0)
P32: polyacetal resin (3.6)
P33: polyamide (2.5)
P34: polyurethane (5.0)
P35: polyester pellet (3.2)
P36: polyethylene (2.3)
P37: (high pressure) polyethylene (2.2)
P38: polydiarylphthalate (3.8)
P39: (low pressure) polyethylene (2.3)
P40: diarylphthalate resin (3.4)
P41: polyethylene oxide (7.8)
P42: cured polyethylene (2.3)
P43: polyethylene terephthalate (2.9)
P44: polycarbonate resin (2.9)
P45: polyvinyl alcohol (2.0)
P46: polybutylene (2.2)
P47: polybutylene (2.25)
P48: polypropylene (2.2)
P49: silicone rubber (3.3)
P50: melamine resin (5.1)
P51: melamine formaldehyde resin (8.0)
P52: cellulose acetate (3.2)
P53: polyvinyl acetate (2.7)
P54: polystyrene (2.3)
P55: styrene butadiene rubber (3.9)
P56: polymonofluoroethylene (2)

Of the foregoing resin polymers are preferred poly(methyl methacrylate), polyacrylonitrile, acetylcellulose, aniline formaldehyde resin, acrylonitrile-styrene resin, acrylonitrile-butylene-styrene resin, ethyl cellulose, nylon 6, nylon 66, polyethylene terephthalate, melamine resin, melamine-formaldehyde resin, cellulose acetate, polyvinyl acetate, polystyrene, styrene-butadiene rubber and polymonofluoroethylene.

Combinations of the foregoing resins or incorporation of particulate material exhibiting a differing dielectric constant to the foregoing resins are also usable. The foregoing resins can be used through solution in solvents such as DMSO, DMF, DME, acetone and methyl ethyl ketone. In place of using a solvent, bulk resin may be thermally melted by heating it to a melting point.

A transmitting piezoelectric layer and a receiving piezoelectric layer can each be preferably selected at an appropriate impedance. A transmitting piezoelectric layer may be prepared by calcination through a lamination technique of a green sheet, subjected to a polarizing treatment and covered with a receiving piezoelectric element or a uniaxially stretched sheet may be superimposed. Specifically, there may be superimposed a polymer thin-layer which has been subjected to uniaxial or biaxial stretching so as to realize the maximum piezoelectric effect.

To allow a low-dielectric layer to adjoin a high-dielectric layer, a ferroelectric polymer dissolved in an appropriate solvent or a melted ferromagnetic polymer may be coated onto the low-dielectric layer. Alternatively, a high-dielectric layer (or ferroelectric film) and a low0dielectric layer (or low-dielectric film), which were preliminarily prepared, may be adhered by applying pressure or by using an adhesive. A pressure is applied in the range of 1 Pa to 1 GPa. A pressure of more than 1 GPa, which requires a special pressurizing machine, is not preferred. A pressure of less than 1 Pa is weak for pressuring, resulting in insufficient adherence. A pressure in the range of 1 kPa to 1 MPa is more preferable for manufacturing.

A polarization treatment is conducted preferably until a maximum polarization is reached and polarization is performed by a direct or alternating current application or a corona discharge treatment. The condition of forming polarization distribution depends on temperature. In the invention the polarization treatment refers to a process of applying a direct or alternating current electric field to a piezoelectric layer provided with electrodes to cause piezoelectric activity in a ferroelectric substance.

A polymer piezoelectric layer (or film) is subjected to a polarization treatment by a direct or alternating current application treatment or a corona discharge treatment, preferably at a unit treatment speed of 1 to 1000 kW/m²/min. In the foregoing range, the polarization treatment is effective and no dielectric breakdown occurs in dielectric heating. The voltage is from 1V to 100 kV and preferably from 100 V to 60 kV; the alternating current frequency is from 10 Hz to 100 MHz, preferably from 100 Hz to 40 MHz, and more preferably from 1 kHz to 30 MHz. The current density is from 0.1 mA to 100 A and preferably from 1 mA to 10A. A voltage, current or frequency falling within the foregoing range results in no dielectric breakdown of the polymer layer and is also at a level higher than the threshold value causing polarization, resulting in no piezoelectric effect. Pulsed voltage application is shorter in application time than a continuous application, rendering it feasible to apply a high voltage.

The treatment rate of direct or alternating current application or corona discharge is represented by a power divided by the product of electrode length (L m) and processing speed (V m/min), namely [Wp/(L x V). A direct or alternating current voltage per unit length of an organic receiving piezoelectric element is preferably in the range of 0.1 MV to 1 GV/m, more preferably 1MV to 0.9 CV/m, and still more preferably 10 MV to 0.5 GV. A voltage falling within the foregoing range causes no breakdown of an organic ferroelectric layer or no polarization. Polarizing time is typically in the range of 1 sec to 12 hrs or 1 sec. to 3 hrs, preferably not more than 1 hr. and more preferably not more than 10 min., taking into account a working step.

PZT is often used as the material of an inorganic transmitting piezoelectric element. Recently lead-free PZTs have been recommended, including quartz, lithium niobate (LiNbO₃), potassium niobate tantalate [K (Ta, Nb) O₃], barium titanate, (BaTiO₃), lithium tantalite (LiTaO₃), strontium titanate (SrTiO₃) and bismuth titanate (BiTiO₃).

Synthesis of polymers used for the receiving organic piezoelectric layer relating to the invention is performed through a radical polymerization using monomers and an initiator, a photopolymerization using a photosensitizer and a vapor-deposition polymerization of vaporizing monomers in an atmosphere of low pressure and low temperature to form a polymer thin-layer. Any one of the foregoing polymerization methods is applicable in the invention by appropriate selection of a monomer and a copolymerization composition. In one of the preferred embodiments of the receiving piezoelectric element, a polyurea is used through vapor deposition polymerization. A polyurea is represented by general formula of (-NH-R-CO-)ₙ, where R represents an alkylene group, a phenylene group, a bivalent heterocyclic group each of which may be substituted. This polyurea may be a copolymer of a urea derivative and other monomers. A preferred polyurea is an aromatic polyurea obtained from 4,4'-diaminodiphenylmethane (denoted simply as MDA) and 4,4'-diphenylmethane diisocyanate (MDI).

A single piezoelectric element is set up, and a backing layer, a acoustic consistency layer, an acoustic lens and the like are further installed therein to prepare a single probe. The number of probes can be increased to 64, 128, 256, 1024, 4096, etc. and they are arranged two-dimensionally to prepare a probe. It may be constituted as a scanner in which two-dimensionally arranged probes are successively scanned to perform imaging.

The ultrasonic probe relating to the invention is provided with a piezoelectric element, which is used as a piezoelectric element for transmitting and receiving ultrasonic waves. In one preferred embodiment of the ultrasonic probe of the invention, the piezoelectric element for transmitting and receiving ultrasonic waves is constituted of at least a piezoelectric element for transmitting ultrasonic waves (which is also denoted simply as a transmitting piezoelectric element) and a piezoelectric element for receiving ultrasonic waves (which is also denoted simply as a receiving piezoelectric element). It is preferred that a transmitting piezoelectric element is layered on a receiving piezoelectric element. It is also preferred that transmitting piezoelectric elements and receiving piezoelectric elements are disposed in a two-dimensional arrangement.

### EXAMPLES

The embodiments of the invention will be further described with reference to examples but are by no means limited to these.

### EXAMPLE 1

### Manufacture of Transmitting Piezoelectric Element

As a transmitting piezoelectric element were manufactured a piezoelectric film (S1) containing no lead and a piezoelectric film (S2) containing lead.

### Piezoelectric element film (S1):

Component materials CaCO₃, La2O₃, Bi₂O₃ and TiO₂ and as a sub-component material MnO were prepared and weighed so that the final composition was (Ca_{0.97} La_{0.03}) Bi_{4.01} Ti₄O₁₅. Subsequently, pure water was added thereto and the mixture was stirred for 8 hrs. in a ball mill containing zirconia media and sufficiently dried to obtain a powdery mixture. The obtained powdery mixture was temporarily molded and calcined in air at 800 °C for 2 hrs. to prepare a calcined material. The calcined material was added with pure water, pulverized in a ball mill containing zirconia media and dried to obtain a powdery raw material for a piezoceramics. This pulverization was varied in duration and conditions to produce various powdery piezoceramic materials having a particle size of 100 nm. Various powdery piezoceramic materials differing in particle size were put in pure water as a binder at 6 percent by mass, press-molded into temporary 100 µm thick plate-shaped molds. The plate-shaped molds were vacuum-packed, and were press-molded at a pressure of 235 MPa. The mold was then calcined and a 20 µm thick sintered material was obtained as a final sinter. The calcination temperature was 1100 °C. Further thereto, an electric field of more than 1.5 x Ec (MV/m) was applied for at least 1 min. to perform a polarization treatment. There was thus obtained piezoelectric element film (S1) containing no lead. Piezoelectric film (S2):

There was manufactured a piezoelectric element of PZT, containing lead. The PZT used in the invention was a material containing lead, zirconium and titanium falling within the range represented by Pb(Zr₁₋ₙTiₙ)O₃ (0.47 ≤ n ≤ 1). Here PZT in which n = 0.2 was manufactured. The individual oxides were each weighed and then, pure water was added thereto and a mixture was stirred in a ball mill containing zirconia media for 8 hrs. and sufficiently dried to obtain a powdery mixture. The obtained powdery mixture was temporarily molded and calcined in the air at 800 °C for 2 hrs. to prepare a calcined material. The calcined material was added with pure water, pulverized in a ball mill containing zirconia media and dried to obtain a powdery raw material for piezoceramics. This pulverization was varied in duration and conditions to produce various powdery piezoceramic materials. Various powdery piezoceramic materials differing in particle size were put in pure water as a binder at 6 percent by mass, press-molded into temporary 100 µm thick plate-shaped molds. The plate-shaped molds were vacuum-packed, and were press-molded at a pressure of 235 MPa. The mold was then calcined at 780 °C and a 21 µm thick sintered material was obtained as a final sinter. Further thereto, an electric field of more than 1.5 x Ec (MV/m) was applied for at least 1 min. to perform a polarization treatment. There was thus obtained piezoelectric element film (S2) containing lead.

The foregoing inorganic piezoelectric element films were provided with electrodes thereon to obtain piezoelectric elements for transmission.

### Manufacture of Receiving Piezoelectric Element

### Organic piezoelectric film (M1):

P(VDF-TrE) film (having a molar ratio of VDF/TrE = 75/25) was manufactured by flow-casting of a dimethyl formamide/acetone solution to obtain a 56 µm thick organic piezoelectric element film (M1) having no low-dielectric. Organic piezoelectric film (M2):

Monomers, 4,4'-diaminodiphenylmethane (MDA) and 4,4'-diphenylmethane diisocyanate (MDI) were subjected to vapor deposition polymerization. MDA was placed in a receiving plate of a vacuum chamber kept at 2x10⁻³ Pa, heated at 100 °C and MDI was also heated at 66 °C, which were deposited to form a 56 µm thick layer on an inorganic piezoelectric membrane which was provided as a substrate in the upper portion of the chamber. The molar ratio of MDA/MDI was 1.1. There was thus obtained a 56 µm thick organic piezoelectric element film (M2) having no low-dielectric film.

### Manufacture of Composite Layer Film

Low-dielectric organic films were appropriately chosen from exemplified resins P1 - P57 and a 50 µm thick resin film was prepared according to the conventional method. Further, the resin film was superimposed on the foregoing 56 µm thick film (M1) or film (M2) and further provided with an electrode layer to obtain an organic piezoelectric element film.

The foregoing inorganic piezoelectric films which were preliminarily molded, were each attached to an electrode by burning and subjected to a polarization treatment. The organic piezoelectric films were each adjoined onto the inorganic piezoelectric element film. The organic piezoelectric layer film (M1 or M2) having no low-dielectric film was subjected as such to polarization treatment. The organic piezoelectric layer films (M1 or M2) having a low-dielectric film chosen from P1 - P57 were also subjected as such to polarization treatment.

Thus, the organic piezoelectric layer films were each subjected to a polarization treatment by using a power source, as described below. Polarizing processes employed the following power sources: for direct current high-voltage power supply HDV-10OK10S (1 to 100 kV) manufactured by Pulse Electronic Engineering Co., Ltd., for alternating current high-voltage power supply KAC15-5VA (0 to 15 kV, 5 mA) manufactured by Kasuga Electric Co., Ltd., for high-voltage alternating current pulse generator PG-3K02 (1 to 3 kV, 0.2 A, 2 to 20 µS for pulse width, 10 to 100 Hz for repetition frequency) and for corona discharge treatment CT-0112 manufactured by Kasuga Denki Co., Ltd. Their use conditions are shown in Table 1. The corona discharge device used has an output of 1 kW, a frequency of 35 kHz and a discharge irradiation unit of W/m₂/min.

After subjected to a polarization treatment, a backing layer and an acoustic consistency layer were provided and ultrasonic probe samples are manufactured. A 7.5 MHz fundamental frequency f1 was emitted, and then, 20 MHz relative receiving sensitivities were obtained with the receiving secondary harmonic f2 of 10 MHz. To measure relative receiving sensitivities, there was used a sound intensity measuring system (1 to 50 MHz), Model 805 manufactured by Sonora Medical System Inc., 2021 Miller Drive Longmont, Colorado (0501 USA). And ordinary consistency layers and backing layers were used. Dielectric breakdown resistance was evaluated in such a manner that a load power (P) was increased to five times and after subjected to a polarization treatment for 10 hrs., the relative receiving sensitivity was evaluated based on the following criteria:
A: lowering of sensitivity being not more than 1% of the sensitivity before subjected to the load test,
B: lowering of sensitivity being more than 1% and not more than 10%, which was acceptable to practice,
C: lowering of sensitivity being more than 10%, which was unacceptable to practice.

The sensitivity shown in Table 1 was represented by a relative value, based on the sensitivity of Sample 102 being 100. Obtained results were not varied in any one of the secondary harmonic wave, the tertiary harmonic wave and the quaternary harmonic wave, provided that when the sensitivity for the secondary harmonic wave of Sample 102 was 100, the sensitivities for the tertiary and quaternary harmonic waves were 82 and 67, respectively.

**Table 1**

| Sample No. | Piezoelectric Element Constitution | | | Polarization Treatment | | | Sensitivity | Resistance to Dielectric Breakdown | Remark |
|---|---|---|---|---|---|---|---|---|---|
| | Inorganic Element | Organic Element | | DC Application (MV/m) | AC Application (MV/m) | Corona Discharge (MV/m) | | | |
| | | High Dielectric Layer (*) | Low Dielectric Layer (*) | | | | | | |
| 101 | S2 | M1(11.0) | - | 120 | - | - | 80 | C | Comp. |
| 102 | S2 | M1 (11.0) | - | - | 120 | - | 100 | C | Comp. |
| 103 | S2 | M1 (11.0) | - | - | - | 120 | 90 | C | Comp. |
| 104 | S2 | M1 (11.0) | P43(2.9) | 120 | - | - | 90 | A | Inv. |
| 105 | S2 | M1 (11.0) | P43 (2.9) | - | 120 | - | 110 | A | Inv. |
| 106 | S2 | M1 (11.0) | P43(2.9) | - | - | 120 | 100 | A | Inv. |
| 107 | S2 | M1 (11.0) | P43 (2.9) | - | 500 | - | 99 | A | Inv. |
| 108 | S2 | M1 (11.0) | P43(2.9) | - | 800 | - | 82 | A | Inv. |
| 109 | S2 | M1 (11.0) | P43(2.9) | - | 1100 | - | 76 | A | Inv. |
| 110 | S2 | M1 (11.0) | P57 (2.0) | 120 | - | - | 90 | A | Inv. |
| 111 | S2 | M1(11.0) | P57(2.0) | - | 120 | - | 110 | A | Inv. |
| 112 | S2 | M1(11.0) | P57 (2.0) | - | - | 120 | 100 | A | Inv. |
| 113 | S2 | M1(11.0) | P17(3.4) | 120 | - | - | 90 | A | Inv. |
| 114 | S2 | M1(11.0) | P17(3.4) | - | 120 | - | 110 | A | Inv. |
| 115 | S2 | M1(11.0) | P17(3.4) | - | - | 120 | 100 | A | Inv. |
| 116 | S1 | M1(11.0) | P50(5.1) | 120 | - | - | 90 | A | Inv. |
| 117 | S1 | M1(11.0) | P50 (5.1) | - | 120 | - | 110 | A | Inv. |
| 118 | S1 | M1(11.0) | P50(5.1) | - | - | 120 | 100 | A | Inv. |
| 119 | S1 | M2(12.0) | P51(8.0) | 120 | - | - | 88 | A | Inv. |
| 120 | S1 | M2(12.0) | P51(8.0) | - | 120 | - | 107 | A | Inv. |
| 121 | S1 | M2(12.0) | P51(8.0) | - | - | 120 | 102 | A | Inv. |

| | | | | | | | | | |
|---|---|---|---|---|---|---|---|---|---|
| *: Dielectric constant | | | | | | | | | |

As apparent from the results shown in Table 1, it was proved that comparing a piezoelectric element of a ferroelectric material layer alone, adjoining a low-dielectric layer onto the ferroelectric material layer produced a piezoelectric element rarely causing dielectric breakdown. It was further proved that superimposing a receiving organic piezoelectric element on the conventional transmitting inorganic piezoelectric element resulted in a highly sensitive ultrasonic probe rarely causing dielectric breakdown.

## Claims

1. A piezoelectric element comprising at least two electrodes having therebetween a composite dielectric layer comprised of a high-dielectric layer and a low-dielectric layer, wherein the high-dielectric layer is comprised of an organic material (1).

2. The piezoelectric element as claimed in claim 1, wherein the low-dielectric layer is comprised of an organic material (2).

3. The piezoelectric element as claimed in claim 1 or 2, wherein the low-dielectric layer exhibits a dielectric constant of from 1 to 10.

4. The piezoelectric element as claimed in any one of claims 1 to 3, wherein the high-dielectric layer exhibits a dielectric constant of more than 10.

5. The piezoelectric element as claimed in any one of claims 1 to 4, wherein the organic material (1) is at least one selected from the group consisting of a vinylidene fluoride-trifluoroethylene copolymer, a vinylidene fluoride-tetrafluoroethylene copolymer, a vinylidene fluoride-perfluoroalkylvinyl ether copolymer, a vinylidene fluoride-perfluoroalkoxyethylene copolymer and a polyurea.

6. The piezoelectric element as claimed in claim 2, wherein the organic material (2) is at least one selected from the group consisting of poly(methyl methacrylate), polyacrylonitrile, acetylcellulose, acrylonitrile-styrene copolymer, ethyl cellulose, nylon 6, nylon 66, polyethylene terephthalate, melamine resin, polyvinyl acetate, polystyrene, styrene-butadiene rubber and poly(monofluoroethylene).

7. A method of manufacturing a piezoelectric element comprising at least two electrodes having therebetween a composite layer comprised of a high-dielectric layer and a low-dielectric layer, the method comprising:
forming the high-dielectric layer and forming the low-dielectric on the high-dielectric layer to form the composite dielectric layer, and
disposing a first electrode on one side of the composite dielectric layer and disposing a second electrode on the other side of the composite dielectric layer,
wherein at least one the high-dielectric layer and the low-dielectric layer is subjected to a polarization treatment and the high-dielectric layer is comprised of an organic material (1).

8. The method as claimed in claim 7, wherein the low-dielectric layer is comprised of an organic material (2).

9. The method as claimed in claim 7 or 8, wherein the low-dielectric layer exhibits a dielectric constant of from 1 to 10.

10. The method as claimed in any one of claims 7 to 9, wherein the high-dielectric layer exhibits a dielectric constant of more than 10.

11. The method as claimed in any one of claims 7 to 10, wherein the high-dielectric layer and the low-dielectric layer are simultaneously subjected to the polarization treatment.

12. The method as claimed in any one of claims 7 to 11, wherein the high-dielectric layer is subjected to the polarization treatment.

13. The method as claimed in any one of claims 7 to 12, wherein the polarization treatment applies a voltage of 1 MV/m to 1 GV/m.

14. The method as claimed in any one of claim 7 to 13, wherein the polarization treatment is a direct current application treatment, an alternating current application method or a corona discharge treatment.

15. An ultrasonic probe for transmitting and receiving an ultrasonic wave, wherein the probe comprises a transmitting piezoelectric element and a receiving piezoelectric element, and the receiving piezoelectric element comprises at least two electrodes having therebetween a composite dielectric layer comprised of a high-dielectric layer and a low-dielectric layer and the high-dielectric layer is comprised of an organic material (1).

16. The ultrasonic probe as claimed in claim 15, wherein the low-dielectric layer is comprised of an organic material (2).

17. The ultrasonic probe as claimed in claim 15 or 16, wherein the low-dielectric layer exhibits a dielectric constant of from 1 to 10.

18. The ultrasonic probe as claimed in any one of claims 15 to 17, wherein the high-dielectric layer exhibits a dielectric constant of more than 10.

19. The ultrasonic probe as claimed in any one of claims 15 to 18, wherein the organic material (1) is at least one selected from the group consisting of a vinylidene fluoride-trifluoroethylene copolymer, a vinylidene fluoride-tetrafluoroethylene copolymer, a vinylidene fluoride-perfluoroalkylvinyl ether copolymer, a vinylidene fluoride-perfluoroalkoxyethylene copolymer and a polyurea.

20. The ultrasonic probe as claimed in any one of claims 15 to 19, wherein the receiving piezoelectric element is superimposed on the transmitting piezoelectric element.
